# EUROPEAN PATENT SPECIFICATION

(11) **EP 0 481 736 B1**
(45) Date of publication and mention of the grant of the patent: **02.02.2000**
(21) Application number: 91309498.3
(22) Date of filing: 16.10.1991
(51) Int. Cl.: H01L 21/48, H01L 23/538

(54) **Method of making an organic resin multi-layer wiring substrate**
Verfahren zum Herstellen eines Mehrschicht-Leitersubstrats aus organischem Harz
Procédé de la fabrication d'un substrat multi-couche de conducteurs à résine organique et procédé de sa fabrication

(30) Priority: 17.10.1990 JP 27810990
(43) Date of publication of application: 22.04.1992
(73) Proprietor: NEC CORPORATION, Tokyo (JP)
(72) Inventor: Kimbara, Kohji, c/o NEC Corporation, Minato-ku, Tokyo (JP)
(74) Representative: Abnett, Richard Charles

(56) References cited:
- EP-A- 0 327 398
- US-A- 4 812 191

## Description

### Background of the Invention

### Field of the Invention

The present invention relates to an organic resin multi-layer wiring substrate and a method of making the same, more specifically to a structure and a method of making a multi-layer wiring substrate using polyimide resin as insulators between layers.

### Description of the prior art

Conventional multi-layer wiring substrates using polyimide resin as an insulator between layers employ polyimide precursor varnish coated on ceramic substrates. After the coated varnish films are dried, holes are formed therethrough and then the curing process is performed to obtain polyimide resin insulation layers. The above steps are repeated to form multi-layer wiring substrates.

In such conventional polyimide multi-layer wiring substrates, the steps of coating polyimide precursor varnish on the ceramic substrate, drying the coated film, boring holes in the coated film and curing it to form the polyimide resin insulation layer must be repeated as many times as the number of laminations of the polyimide resin insulation layers. Accordingly, a major disadvantage of the conventional polyimide multi-layer wiring substrates is the extremely long time required to perform the lamination steps.

Another disadvantage of the conventional polyimide multi-layer wiring substrates is degradation of the polyimide resin due to the repeated heat stress in the multiple curing steps of the polyimide resin underlying the wiring layers.

US Patent No. US-A-4812191, on which the claims of this application are based, describes a process for making a multi-layer wiring substrate by joining multiple subassemblies. Each subassembly comprises a lamination block which is formed over a sacrificial substrate. A supporting ring is then adhered to the face of the subassembly opposite the substrate and the substrate removed by acid etching. Two subassemblies are then adhered together with the faces of the two subassemblies which were adjacent their substrates abutting each other. The support rings are then removed and the fastened subassemblies mounted on a base plate by means of an adhesive. Holes can then be formed through the two subassemblies for electrically connecting them.

European Patent Application No. EP-A-0327398 describes the use of KrF and XeCl excimer lasers for forming holes through polymers including polyimides.

### Summary of the Invention

The present invention provides a method of making an organic resin multi-layer wiring substrate as defined in the appendant independent claim. Preferred features of the invention are defined in dependent subclaims.

The present invention may thus advantageously provide a method of making an organic resin multi-layer wiring substrate which is capable of avoiding degradation of the organic resin and considerably reducing the time required for the lamination steps.

Other objects and features may best be understood by reference to the following detailed description and accompanying drawings.

### Brief Description of the Drawing

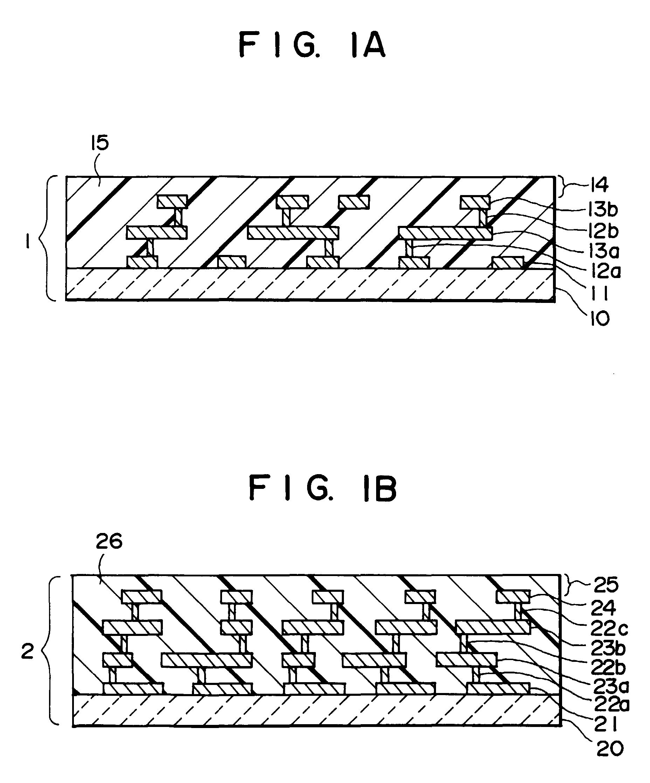

Figures 1A - 1F illustrate a series of steps of making the polyimide multi-layer wiring substrate according to one embodiment of the present invention.

### Detailed Description of the Preferred Embodiment

Now, the present invention will be described in detail by reference to the accompanying drawings illustrating one preferred embodiment.

Illustrated in Figures 1A - 1F are the steps of making the polyimide multi-layer wiring substrate according to one embodiment of the present invention. In the polyimide multi-layer wiring substrate in the particular embodiment illustrated, the thickness of the insulator between the wiring layers is 20 µm, the signal line width is 25µm and the thickness of the signal line is 10µm. Photosensitive polyimide and gold are used as the polyimide resin and wiring metal, respectively.

Ground and connection layers 11 are first patterned on a flat aluminum plate 10 by photolithography using photoresist. A gold electroplating process is performed to form the ground and connection layers 11 (step 1). A photosensitive polyimide precursor varnish is then coated on the aluminum plate 10 having the ground and connection layers 11 thereon. Holes 12a are bored at desired locations by exposing to light and developing the photosensitive polyimide varnish before curing it to form a polyimide insulation layer 15 (step 2 ). A signal wiring layer 13a is formed on the polyimide insulation layer 15 in a step similar to step 1. Also, holes 12b are bored at desired locations in a step similar to step 2 and the polyimide insulation layer 15 is formed on the signal wiring layer 13a as the insulation layer between signal layers.

On the polyimide insulation layer 15, a signal wiring layer 13b is formed in a step similar to step 1 (step 3). Polyimide precursor varnish is coated on the signal wiring layer 13b formed in step 3 to obtain a coating layer 14 (step 4). It is to be noted here that the coating layer 14 remains un-cured to be subsequently used as an adhesive layer and that no photolithography is performed to form holes. The above steps 1 through 4 form a set of discrete signal wiring layers 13a, 13b and the ground and connection wiring layers 11 on the flat aluminum plate 10 required for a multi-layer wiring substrate [See FIG. 1A].

The alternate lamination of the signal wiring layers 13a, 13b, the ground and connection wiring layer 11, the polyimide insulation layer 15 and the coating layer 14 on the flat aluminum plate 10 define a lamination block 1. Then, a ground and connection layer 21 is patterned on a ceramic substrate 20 using photoresist and photolithographic technology and gold electroplating (step 5). Subsequently, a photosensitive polyimide precursor varnish is coated on the ceramic substrate 20 having the ground and connection layer 21 thereon and holes 22a are formed at desired locations by exposing to light and developing before curing to form a polyimide insulation layer 28 ( step 6 ).

A similar step to step 5 is repeated to form a signal wiring layer 23a on the polyimide insulation layer 28. Also, a similar step to step 6 is repeated to form holes 22b at desired locations. Also formed on the signal wiring layer 23a is the polyimide insulation layer 28 to act as an insulator between signal layers. Furthermore, a similar step to step 5 is performed to form a signal wiring layer 23b on the polyimide insulation layer 26 (step 7).

A similar step to step 8 is performed to form holes 22c at desired locations on the signal wiring layer 23b formed in step 7 and also the polyimide layer 28 is formed as an insulator between the signal layers (step 8). Formed on the polyimide insulation layer 26 is a ground and connection layer 24 in a step similar to step 5 (step 9). A polyimide precursor varnish is coated on the ground and connection layer 24 formed in step 9 to form a coating layer 25 (step 10). It is to be noted here that the coating layer 25 remains un-cured and no holes are formed by photo lithography for subsequently using as an adhesive layer.

The steps 5 through 10 form a set of discrete signal wiring layers 23a, 23b and the ground and connection layers 21,24 on the ceramic substrate 20 required for a multi-layer wiring substrate [See FIG.1B]. The alternately formed signal wiring layers 23a, 23b, ground and connection layers 21, 24, polyimide insulation layer 26 and coating layer 25 on the ceramic substrate 20 define a lamination block 2.

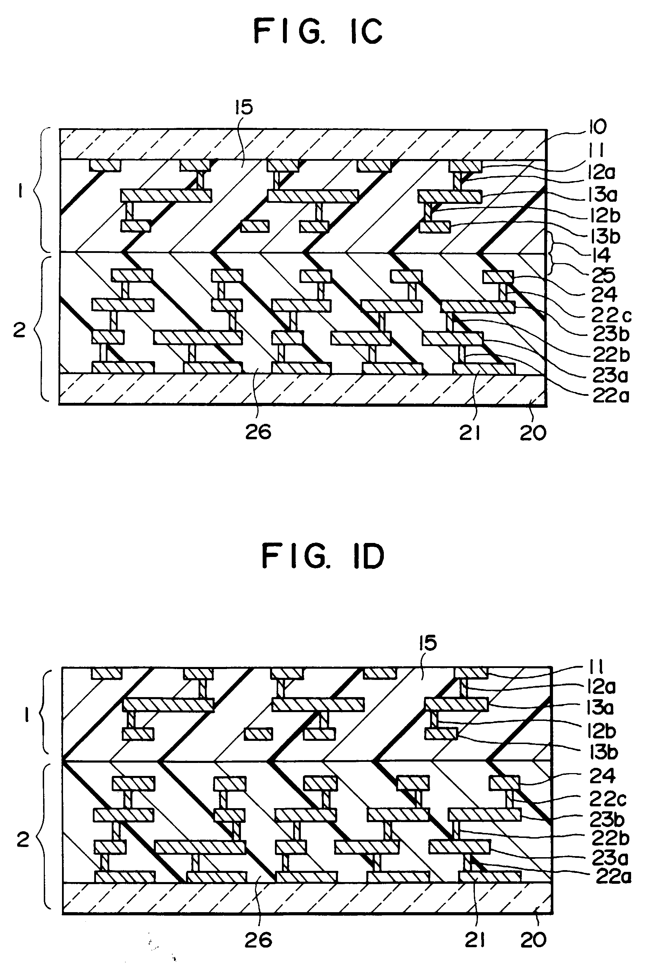

Then, the lamination block 1 made through the above steps 1 through 4 and the lamination block 2 made through the above steps 5 through 10 are stacked with the coating layer 14 abutting against the coating layer 25 and with proper alignment therebetween. The two lamination blocks 1 and 2 are compressed and heated at relatively low temperature to adhere polyimide films of the coating layers 14 and 25 in the lamination blocks 1 and 2 for preliminary fixation without gassing (step 11)[See FIG.1C].

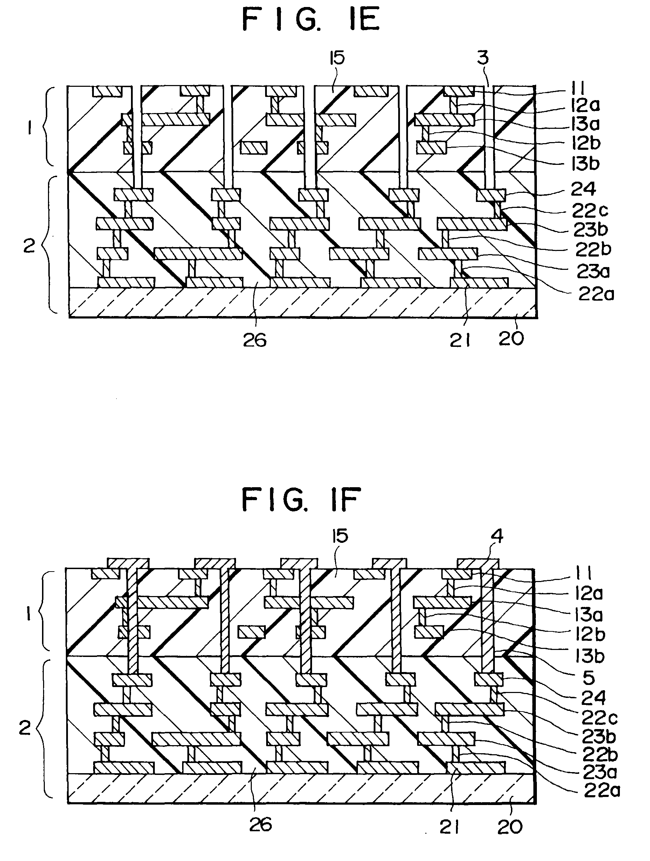

After preliminary fixation of the lamination blocks 1 and 2, they are immersed in 16 % water solution of hydrochloric acid to remove the aluminium plate 10 by dissolution. It is to be noted that polyimide resin is stable to acid even if it is in uncured condition. Following the removal of the aluminium plate 10 from the lamination blocks 1 and 2, they are heated up to 350°C for complete curing (step 12) [See FIG.1D]. Via holes 3 are bored in the completely cured lamination blocks 1 and 2 in such a manner that the ground and connection layer 24 formed in the step 10 acts as pads (step 13) [See FIG.1E]. A KrF excimer laser with laser output energy of 1 J/cm² is used to etch the polyimide layer for boring the via holes 3. The laser output energy is chosen to etch only the polyimide layer but not the gold layer, thereby terminating each hole at the ground and connection layer 24.

A palladium series catalyst solution is contacted with the polyimide surface and the inner walls of the holes 3 made in the step 13 to activate the polyimide surface and the inner walls of the holes 3. The lamination blocks 1 and 2 after surface treatment of the polyimide surface and the holes 3 are immersed in a gold electroless plating bath to deposit gold platings 4 and 5 on the polyimide surface and inside the holes 3. At this time, a resist pattern is formed on the polyimide surface with the aluminum plate 10 removed to interconnect the holes 3a and the ground and connection layer 11 made in step 1, thereby preventing the gold from depositing at unnecessary areas of the polyimide surface (step 14) [See FIG.1F].

One or more lamination blocks made as in the above steps 1 through 4 is further laminated and integrated on the polyimide wiring lamination assembly ( the lamination blocks 1 and 2 ) made in steps 11 through 14 by further repeating the above steps 11 through 14 as many times as required for integration ( step 15 ).

The number of curing steps of the polyimide resin under the multiple wiring layers required by repeating the above steps 1 through 15 is reduced by comparison to conventional methods and so may prevent the polyimide resin from degrading and enable the manufacture of highly laminated, high density polyimide multi-layer wiring substrates in much shorter time than by the conventional technique.

Although gold is used as the metal wiring material in this particular embodiment, copper or other low resistance metal may be used. The photosensitive polyimide precursor varnish used for adhering polyimide wiring layers need not be photosensitive as long as it is adhesive.

It is to be understood from the above description that reduced degradation of polyimide resin and shorter lamination time of the multi-layer wiring substrate can be achieved by the particular method of fabrication. That is, the lamination block 1 is made by alternately laminating the wiring layers such as the ground and connection layer 11, the signal wiring layers 13a, 13b, etc. and the polyimide insulation layers 15 on the flat aluminum plate 10. The lamination block 2 is made by alternately laminating the wiring layers such as the ground and connection layers 21, 24, the signal wiring layers 23a,23b, etc. and the polyimide insulation layers 26 on the ceramic substrate 20. The lamination blocks 1 and 2 are stacked with each other and the aluminum plate 10 is removed from the lamination block 1. Subsequently, the holes 3 are bored in the two lamination blocks 1, 2 to interconnect them.

As described above, the present invention mat advantageously prevent polyimide resin from degrading and reduce the time required for laminating the multi-layer wiring substrate by stacking a plurality of lamination blocks, each made by alternately laminating a plurality of electrically conductive wiring layers and a plurality of insulation layers of organic resin and then boring holes or apertures to provide paths for electrically interconnecting the plurality of lamination blocks.

## Claims

1. A method of making an organic resin multi-layer wiring substrate comprising the steps of:
forming first (2) and second (1) lamination blocks on first (20) and second (10) hard plates by depositing over each hard plate a laminated plurality of alternate layers of electrically conductive wiring layers and organic resin insulation, the topmost layer of each block (25, 14) being a layer of un-cured organic resin, and the first hard plate being a ceramic substrate;
performing preliminary fixing of the first and second lamination blocks together, with their respective hard plates in place and with their respective topmost layers abutting each other, by adhering the topmost layers together and by applying heat and pressure;
removing the second hard plate from the second lamination block by dissolution of the second hard plate;
curing the un-cured, abutting, topmost layers of the first and second lamination blocks; and
forming holes (3) extending through the second lamination block into the first lamination block for electrically connecting the two blocks.

2. A method according to claim 1, in which the second hard plate is of aluminium.

3. A method according to claim 1 or 2, in which at least one of the topmost layers of the first and second lamination blocks is of adhesive polyimide varnish.

4. A method according to claim 2, in which forming the second lamination block comprises the steps of electroplating ground and connection layers of gold on the aluminium hard plate using a photolithography technique, coating a photosensitive polyimide varnish layer thereover, forming holes in the polyimide layer by exposing it to light and developing it, and curing the polyimide layer to form a polyimide insulation layer.

## Patentansprüche

1. Verfahren zum Herstellen eines Mehrschicht-Leitersubstrats aus organischem Harz mit den Schritten:
Ausbilden erster (2) und zweiter (1) Laminationsblöcke auf ersten (20) und zweiten (10) harten Platten indem über jeder harten Platte mehrere abwechselnd laminierte Schichten bestehend aus elektrisch leitenden Verdrahtungsschichten und organischer Harzisolation abgeschieden werden, wobei die oberste Schicht jedes Blocks (25, 14) eine Schicht aus einem ungehärteten organischen Harz ist, und die erste harte Platte ein Keramiksubstrat ist;
Durchführen einer vorläufigen Fixierung der ersten und zweiten Laminationsblöcke aneinander, wobei deren harten Platten in ihrer Lage bleiben und wobei deren entsprechenden obersten Lagen aneinandergrenzen, durch Verkleben der obersten Schichten miteinander und durch Aufbringen von Wärme und Druck;
Entfernen der zweiten harten Platte von dem zweiten Laminationsblock durch Auflösen der zweiten harten Platte;
Härten der ungehärteten, angrenzenden, obersten Schichten der ersten und zweiten Laminationsblöcke; und
Ausbilden von Löchern (3), welche sich durch den zweiten Laminationsblock hindurch in den ersten Laminationsblock hinein eretrecken, um die zwei Blöcke elektrisch miteinander zu verbinden.

2. Verfahren nach Anspruch 1, in weichem die zweite harte Platte aus Aluminium besteht.

3. Verfahren nach Anspruch 1 oder 2, in welchem mindestens eine von den obersten Schichten der ersten und zweiten Laminationsblöcke aus einem klebenden Polyimidlack besteht.

4. Verfahren nach Anspruch 2, in weichem die Ausbildung des zweiten Laminationsblockes die Schritte einer Elektroplattierung von Masse- und Verbindungsschichten aus Gold auf der harten Aluminiumplatte unter Anwendung einer Photolithographietechnik, eines Schichtauftrags einer photoempfindlichen Polyimidlackschicht darüber, einer Ausbildung von Löchern in der Polyimidschicht, indem diese Licht ausgesetzt und entwickelt wird, und einer Härtung der Polyimidschicht zur Ausbildung einer Polyimidisolationsschicht aufweist.

## Revendications

1. Procédé de fabrication d'un substrat de câblage multicouche de résine organique comprenant les étapes consistant à :
former des premier (2) et deuxième (1) blocs de stratification sur des première (20) et deuxième (10) plaques dures en déposant sur chaque plaque dure une pluralité stratifiée de couches alternées de couches de câblage électriquement conductrices et d'un isolant de résine organique, la couche supérieure de chaque bloc (25, 14) étant une couche de résine organique non durcie, et la première plaque dure étant un substrat en céramique ;
procéder à un assemblage préalable des premier et deuxième blocs de stratification ensemble, leurs plaques dures respectives étant en place et leurs couches supérieures respectives venant en butée l'une contre l'autre, en faisant adhérer les couches supérieures l'une avec l'autre et en appliquant de la chaleur et de la pression ;
retirer la deuxième plaque dure du premier bloc de stratification en dissolvant la deuxième plaque dure ;
faire durcir les couches supérieures en butée et non durcies des premier et deuxième blocs de stratification ; et
former des trous (3) s'étendant à travers le deuxième bloc de stratification dans le premier bloc de stratification pour relier électriquement les deux blocs.

2. Procédé selon la revendication 1, dans lequel la deuxième plaque dure est en aluminium.

3. Procédé selon la revendication 1 ou 2, dans lequel au moins une des couches supérieures des premier et deuxième blocs de stratification est faite en vernis polyimide adhésif.

4. Procédé selon la revendication 2, dans lequel la formation du deuxième bloc de stratification comprend les étapes consistant à galvaniser des couches de masse et de connexion en or, sur la plaque dure en aluminium à l'aide d'une technique de photolithographie, déposer une couche de vernis polyimide photosensible par dessus, former des trous dans la couche de polyimide en l'exposant à la lumière et en la développant, et faire durcir la couche de polyimide pour former une couche isolante de polyimide.
